# EUROPEAN PATENT SPECIFICATION

(11) **EP 4 016 073 B1**
(45) Date of publication and mention of the grant of the patent: **23.10.2024**
(21) Application number: 21214302.8
(22) Date of filing: 14.12.2021
(51) Int. Cl.: G01N 29/04, G01N 29/06, G01N 29/44

(54) **STRUCTURAL INCONSISTENCY DETECTION USING DISTANCE DATA**
ERKENNUNG VON STRUKTURELLEN INKONSISTENZEN MIT ABSTANDSDATEN
DÉTECTION D'INCOHÉRENCE STRUCTURELLE À L'AIDE DE DONNÉES DE DISTANCE

(30) Priority: 17.12.2020 US 202063126971 P
(43) Date of publication of application: 22.06.2022
(73) Proprietor: The Boeing Company, Arlington, VA 22202 (US)
(72) Inventor: ERDIM, Huseyin, Chicago, 60606-1596 (US); ORTIZ, Alejandro Alberto, Chicago, 60606-1596 (US); DRUMHELLER, Michael, Chicago, 60606-1596 (US); WALKER, Eric James, Chicago, 60606-1596 (US)
(74) Representative: Bryn-Jacobsen, Caelia

(56) References cited:
- WO-A1-2013/044350
- US-A1- 2014 207 419

## Description

### FIELD

This disclosure generally relates to the nondestructive inspection and, more particularly, to detecting structural inconsistencies using nondestructive inspection and design distance data.

### BACKGROUND

Nondestructive inspection (NDI) is a testing and analysis technique used to evaluate the properties of a structure without causing damage to the structure. Nondestructive inspection may be also referred to as nondestructive testing (NDT), nondestructive examination (NDE), and nondestructive evaluation (NDE). Evaluating the data generated via some currently available nondestructive inspection techniques may be challenging with respect to large structures with complex shapes, such as fuselage structures, wing structures, and other types of aircraft structures. For example, an ultrasound device may be used to generate measurements (e.g., distance measurements between different surfaces, thickness measurements, etc.) for a fuselage structure. But currently available methodologies may not provide an accurate and reliable way to analyze these measurements with respect to the design data for the fuselage structure. Manual techniques for comparing such measurements with design data may be more cumbersome and time-consuming than desired.

WO2013/044350A1 in an abstract states that "A device and method for performing ultrasound scanning of a substantially cylindrical object, the device comprising a cuff adapted to fit around a circumference of the object, a carrier mounted slidably on the cuff and adapted to traverse the circumference of the object, an ultrasound probe mounted on the carrier and positioned to scan the circumference of the object as the carrier traverses the circumference of the object, a carrier motor mounted on the cuff or the carrier and used to drive the movement of the carrier about the circumference of the object, and one or more data connections providing control information for the carrier motor and the ultrasound probe and receiving scanning data from the ultrasound probe."

US2014/207419A1 in an abstract states that "A system is provided that includes computer-readable storage configured to store non-destructive testing inspection data relating to a portion of an object that has been inspected. Further, a processor presents a model associated with the object, associates the inspection data with the related portion of the object; and presents an indication of availability of the inspection data on a portion of the presented model. The portion of the presented model relates to the portion of the object associated with the inspection data."

### SUMMARY

The present invention is set out in the independent claims, with some optional features set out in the claims dependent thereto.

In one or more examples, a method is provided for inspecting a structure. A scan surface that represents an inspection area of the structure is identified. A plurality of sample points on an outer surface identified from a model of the structure and a corresponding plurality of projected points on an inner surface identified from the model of the structure are generated using the scan surface, a first geometric representation of the outer surface, and a second geometric representation of the inner surface. Distance data is computed using the plurality of sample points and the corresponding plurality of projected points. Sensor data generated for the inspection area of the structure is analyzed using the distance data to detect a presence of an inconsistency in the structure. In one or more examples, a system comprises a memory for storing a machine-readable medium comprising machine executable code and a processor coupled to the memory. The processor is configured to execute the machine executable code to cause the processor to implement an analysis tool that is configured to: identify a scan surface that represents an inspection area of a structure; generate a plurality of sample points on an outer surface identified from a model of the structure and a corresponding plurality of projected points on an inner surface identified from the model of the structure using the scan surface, a first geometric representation of the outer surface, and a second geometric representation of the inner surface; and compute distance data using the plurality of sample points and the corresponding plurality of projected points, wherein the distance data identifies a distance between a point pair formed by a sample point of the plurality of sample points and a projected point of the corresponding plurality of projected points.

In one or more examples, a method for computing distance data for an aircraft structure is provided. A scan surface that represents an inspection area of the aircraft structure is identified. An outer surface for the aircraft structure and a set of inner surfaces for the aircraft structure are identified using a model of the aircraft structure. A plurality of sample points on the outer surface and, for each selected inner surface of the set of inner surfaces, a corresponding plurality of projected points on the selected inner surface are generated using the scan surface, a first geometric representation of the outer surface, a second geometric representation of the selected inner surface, and a spatial indexing algorithm. Distance data is computed using the plurality of sample points and the corresponding plurality of projected points generated for each selected inner surface of the set of inner surfaces. The distance data provides as-designed data for use in comparing with sensor data generated for the aircraft structure to detect an inconsistency in the aircraft structure.

The features and functions can be achieved independently in various embodiments of the present disclosure or may be combined in yet other embodiments in which further details can be seen with reference to the following description and drawings.

### BRIEF DESCRIPTION OF THE DRAWINGS

The novel features believed characteristic of the example embodiments are set forth in the appended claims. The example embodiments, however, as well as a preferred mode of use, further objectives and features thereof, will best be understood by reference to the following detailed description of an example embodiment of the present disclosure when read in conjunction with the accompanying drawings.
**Figure 1** is a block diagram of an inspection system in accordance with one or more example embodiments.
**Figure 2** is a schematic diagram of a process for generating a scan surface in accordance with one or more example embodiments.
**Figure 3** is schematic diagram of a process for generating a plurality of sample points on the scan surface from **Figure 2** in accordance with one or more example embodiments.
**Figure 4** is a schematic diagram of a geometric representation that has been generated using the model of the structure from **Figure 1** in accordance with one or more example embodiments.
**Figure 5** is a schematic diagram of a relevant surface area that has been identified from the geometric representation in **Figure 4** in accordance with one or more example embodiments.
**Figure 6** is an illustration of a thickness map in accordance with one or more example embodiments.
**Figure 7** is a flowchart of a process for inspecting a structure in accordance with one or more example embodiments.
**Figure 8** is a flowchart of a process for identifying a scan surface in accordance with one or more example embodiments.
**Figure 9** is a flowchart of a process for generating sample points in accordance with one or more example embodiments.
**Figure 10** is a flowchart of a process for generating projected points in accordance with one or more example embodiments.
**Figure 11** is a flowchart of a process for identifying a relevant surface area for a surface in accordance with one or more example embodiments.
**Figure 12** is a flowchart of a process for generating a set of functions for a structure in accordance with one or more example embodiments.
**Figure 13** is a flowchart of a process for identifying a plurality of scan points in accordance with one or more example embodiments.
**Figure 14** is a flowchart of a process for computing distance data for an aircraft structure in accordance with one or more example embodiments.
**Figure 15** is a block diagram of a data processing system in accordance with an example embodiment.
**Figure 16** is an illustration of an aircraft manufacturing and service method in accordance with an example embodiment.
**Figure 17** is a block diagram of an aircraft in accordance with an example embodiment.

### DETAILED DESCRIPTION

The example embodiments described below provide methods and systems for generating as-designed data for use in conjunction with sensor data to detect the presence of structural inconsistencies. The as-designed data includes as-designed distance data. This as-designed data identifies the distances between various surface layers within a structure that are designed for the structure. As one example, for an aircraft structure, the as-designed data may provide the theoretical distance between an outer mold line and an inner mold line of the aircraft structure at various locations along the aircraft structure.

The example embodiments described herein provide methods and systems for automating the process of computing the as-designed data. These methods and systems provide cost savings and time savings as compared to using manual techniques that are currently available. The as-designed data includes distance data identifying distances for each of a plurality of sample points. In some examples, these distances include thicknesses, such as part thicknesses, material thicknesses, etc.

For example, the distance data may be computed for each of a plurality of inspection areas designated for a structure. An inspection area may be an area, section, or zone of the structure that is designated for inspection in a single pass. Within this inspection area, an inspection device (e.g., a nondestructive inspection device) may follow a pattern comprising a plurality of paths and a plurality of scan locations along each path of the plurality of paths. In one or more examples, the sample points are the theoretical or abstract representation of the scan locations at which nondestructive inspection has been or is to be performed.

Further, the example embodiments described herein provide methods and systems for generating a function that enables these types of as-designed distances to be computed for any location on a structure regardless of the scan pattern used to inspect the structure. This function may be, for example, a continuous function. Thus, the automated process of computing distance data may not need to be repeated for different types of scan patterns or previously unrepresented scan locations.

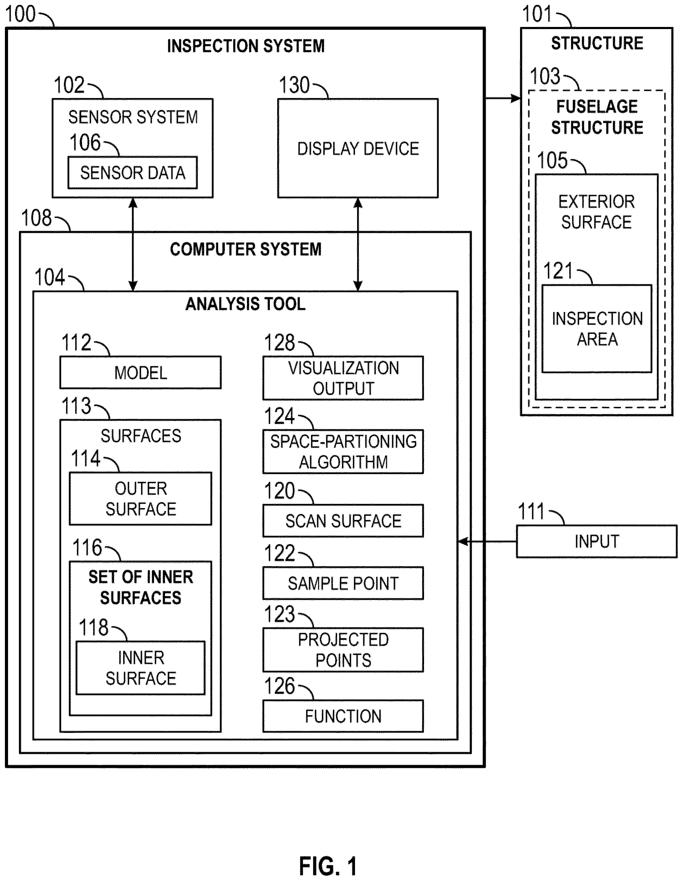

Referring now to the figures, **Figure 1** is a block diagram of an inspection system in accordance with one or more example embodiments. Inspection system **100** may be used to inspect structure **101.** In one or more examples, structure **101** is a composite structure, with inspection system **100** being used to perform nondestructive inspection of the composite structure.

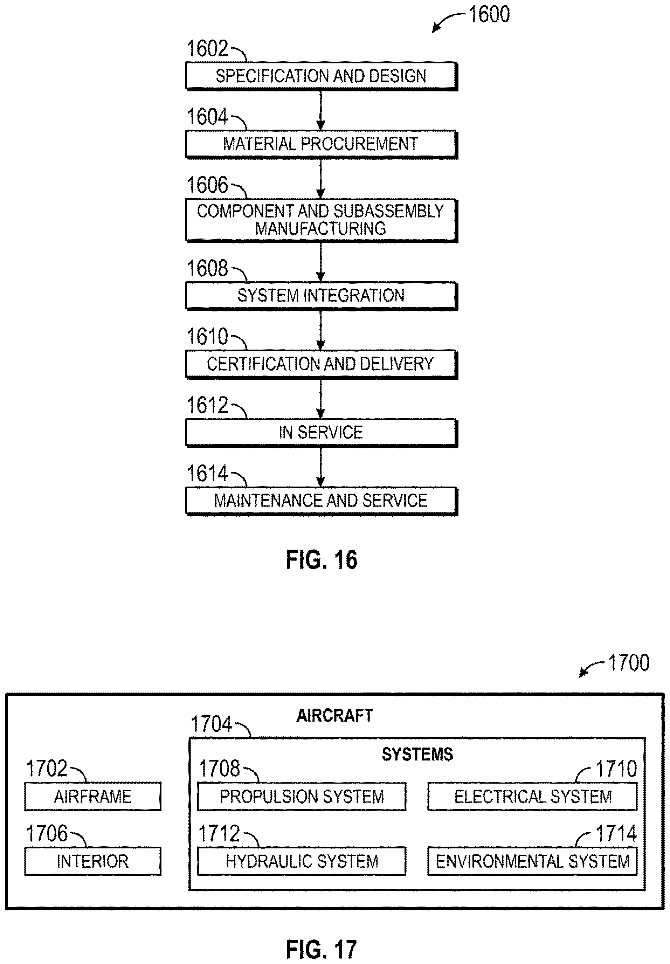

Structure **101** may take any of a number of different forms. In one or more examples, structure **101** takes the form of an aircraft structure. For example, structure **101** may take the form of fuselage structure **103** (e.g., a barrel fuselage structure). Fuselage structure **103** may be an entire fuselage of an aircraft, such as aircraft **1700** described below with respect to **Figure 17****,** or may be a portion of a fuselage. In other examples, structure **101** takes the form of a wing structure, a tail section, a nose section, a control surface structure (e.g., a flap, a stabilizer, an aileron, etc.). Thus, depending on the implementation, structure **101** may be a part, an assembly, a system, a collection of surfaces, or some other type of structural entity.

In one or more examples, inspection system **100** includes sensor system **102** and analysis tool **104.** Sensor system **102** may include one or more sensors that are used to generate sensor data **106.** In one or more examples, sensor system **102** includes at least one nondestructive inspection (NDI) device. An NDI device may include one or more sensors for performing nondestructive inspection.

For example, without limitation, an NDI device may include an ultrasonic device (e.g., an ultrasonic transducer) for performing ultrasonic inspection of structure **101.** During inspection, the ultrasonic device may be moved (or scanned) over structure **101.** The ultrasonic device may be separated from exterior surface **105** of structure **101** by a couplant (e.g., oil) or water.

Sensor system **102** generates sensor data **106** that is used to determine whether structure **101** has any inconsistencies. As used herein, an inconsistency may be an undesired feature or a feature that is outside of the design of or selected tolerances for structure **101.** For example, an inconsistency may be a void, a crack, a certain level of porosity, delamination, some other type of inconsistency or a combination thereof. In one or more examples, sensor data **106** includes measurements or data that can be used to calculate distances between different surfaces of structure **101.** At least a portion of these distances may identify or may be used to identify thicknesses for different parts of structure **101** or layers of parts.

In one or more examples, analysis tool **104** may be communicatively coupled to sensor system **102.** For example, analysis tool **104** may be capable of communicating with sensor system **102** over at least one of a wireless communications link, a wired communications link, an optical communications link, or a combination thereof.

Analysis tool **104** may be implemented using hardware, software, firmware, or a combination thereof. When software is used, the operations performed by analysis tool **104** may be implemented using, for example, without limitation, program code configured to run on a processor unit. When firmware is used, the operations performed by analysis tool **104** may be implemented using, for example, without limitation, program code and data and stored in persistent memory to run on a processor unit.

When hardware is employed, the hardware may include one or more circuits that operate to perform the operations performed by analysis tool **104.** Depending on the implementation, the hardware may take the form of a circuit system, an integrated circuit, an application specific integrated circuit (ASIC), a programmable logic device, or some other suitable type of hardware device configured to perform any number of operations.

A programmable logic device may be configured to perform certain operations. The device may be permanently configured to perform these operations or may be reconfigurable. A programmable logic device may take the form of, for example, without limitation, a programmable logic array, a programmable array logic, a field programmable logic array, a field programmable gate array, or some other type of programmable hardware device.

In one or more examples, analysis tool **104** is implemented within computer system **108.** Computer system **108** may take the form of any of a number of different types of computing platforms. For example, computer system **108** may include a single computer or multiple computers in communication with each other. In other examples, computer system **108** may take the form of a cloud computing system, a smartphone, a tablet, or some other type of computing platform.

Analysis tool **104** is used to generate distance data **110** that can be used in conjunction with sensor data **106** to detect any inconsistencies in structure **101.** In some examples, analysis tool **104** is itself capable of performing an analysis of sensor data **106** using distance data **110** to detect inconsistencies in structure **101.** In one or more examples, analysis tool **104** may receive input **111** that is used to generate distance data **110.** Input **111** may include user input, input from a program, input from a different computing platform, data retrieved from a database or some other data store, some other type of input, or a combination thereof. Input **111** may identify, for example, user (or customer) requirements.

Distance data **110** comprises data identifying different distances between one or more surface pairs associated with structure **101.** A surface pair comprises two surfaces that are aligned (e.g., overlap). For example, distance data **110** may identify the distance between a first location along an outer surface of a fuselage skin and a second location on an inner surface of the fuselage skin. The second location on the inner surface lies along a vector that is substantially normal to the outer surface at the first location. As used herein, "substantially normal" means normal or nearly normal, with selected tolerances. Distance data **110** may include any number of distances for any number of surface pairs.

Distance data **110** is generated based on the design of structure **101.** Accordingly, distance data **110** may be referred to as design distance data, design-based distance data, or as-designed distance data. In one or more examples, a distance identified in distance data **110** may be a thickness of a part or portion of structure **101.** Thus, in some cases, at least a portion of distance data **110** may include thickness data. This thickness data may be also referred to as design thickness data, design-based thickness data, or as-designed thickness data.

In these examples, analysis tool **104** generates distance data **110** based on model **112** of structure **101.** Model **112** may be a data-based representation of structure **101.** For example, model **112** may be a computer-aided design (CAD) model of structure **101.** In some examples, model **112** comprises data that can be used to construct a three-dimensional model of structure **101.** In or more examples, model **112** is received in input **111.**

Analysis tool **104** uses model **112** to identify a plurality of surfaces **113** for structure **101.** These surfaces **113** are the as-designed surfaces for structure **101.** In one or more examples, surfaces **113** includes outer surface **114** and set of inner surfaces **116.** Set of inner surfaces **116** includes one or more inner surfaces of structure **101.** Each surface of surfaces **113** may be a continuous surface or a discontinuous surface.

When structure **101** takes the form of an aircraft structure such as fuselage structure **103,** outer surface **114** may be an outer mold line (OML) of fuselage structure **103,** which is the outermost surface of fuselage structure **103.** This outer mold line may be formed by, for example, at least the outer surface of the fuselage skin.

In this example, inner surface **118** is one example inner surface in set of inner surfaces **116** for fuselage structure **103.** Inner surface **118** may be a surface that is located closer to a center axis of fuselage structure **103** as compared to outer surface **114.** For example, fuselage structure **103** may have a barrel shape, a cylindrical shape, a cylinder-type shape, or similar. In some examples, inner surface **118** is the surface of the fuselage skin facing the interior of fuselage structure and forms at least a portion of the inner mold line (IML) of fuselage structure **103.** In some examples, inner surface **118** is a surface formed by the filler material used in fuselage structure **103.** In other examples, inner surface **118** is a surface formed by the various outer surfaces or the various inner surfaces of stringers of fuselage structure **103.**

Analysis tool **104** further identifies scan surface **120.** Scan surface **120** is a representation of an area of structure **101** that has been inspected (or "scanned") using sensor system **102** or that is to be inspected using sensor system **102.** This area may be referred to as an inspection area of an inspection zone. For example, scan surface **120** may represent inspection area **121** over exterior surface **105** of structure **101.**

Analysis tool **104** generates a plurality of sample points **122** and, for each surface of set of inner surfaces **116,** a corresponding plurality of projected points **123** using scan surface **120,** outer surface **114,** set of inner surfaces **116,** and spatial indexing algorithm **124.** Sample points **122** are located along outer surface **114.** As used herein, a "sample point" is a point (e.g., defined with respect to three dimensions) that is projected from scan surface **120** at a vector substantially normal to scan surface **120** and that lies on or is coincident with outer surface **114.**

Projected points **123** are located along an inner surface (e.g., inner surface **118**) of set of inner surfaces **116.** As used herein, a "projected point" on an inner surface is a point (e.g., defined with respect to three dimensions) that is projected from a corresponding one of sample points **122** along a vector that is substantially normal to outer surface **114** and that lies on or is coincident with the inner surface.

Sample points **122** and projected points **123** may be generated using spatial indexing algorithm **124.** In one or more examples, spatial indexing algorithm **124** is used to identify a portion of model **112** most relevant to generating sample points **122** and projected points **123.** Thus, spatial indexing algorithm **124** may be used to reduce the data that needs to be processed to generate sample points **122** and projected points **123,** thereby reducing the overall time and processing resources needed to generate distance data **110.**

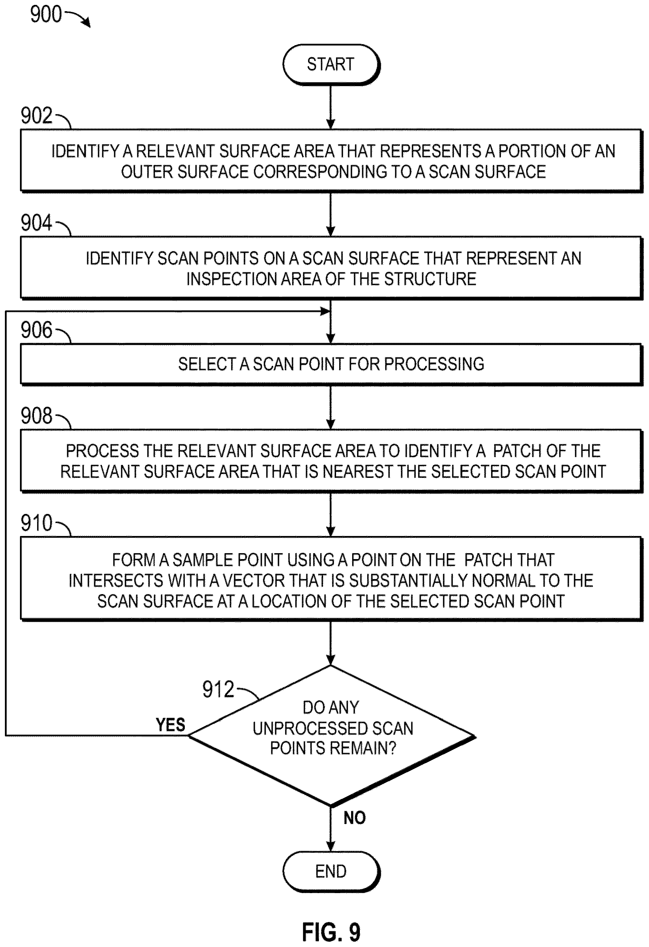

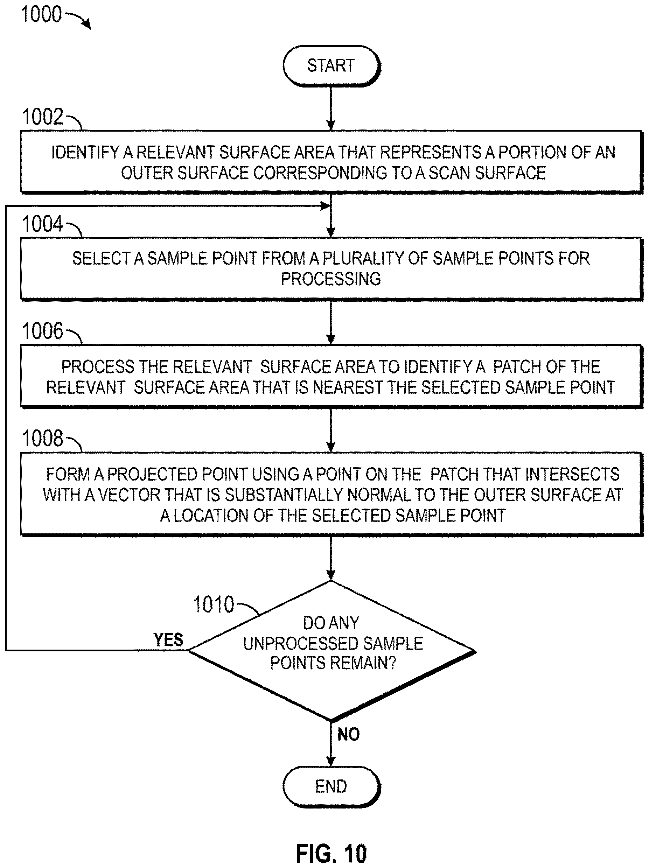

For example, analysis tool **104** may use spatial indexing algorithm **124** to narrow down a portion of inner surface **118** that is aligned with or overlapped by scan surface **120** such that the entirety of inner surface **118** does not need to be processed in order to generate projected points **123.** Spatial indexing algorithm **124** may comprise, for example, but is not limited to, one or more algorithms for building k-dimensional trees. Examples of how sample points **122** and projected points **123** may be generated are described in greater detail below in **Figure 9** and **Figure 10****,** respectively.

Using sample points **122** and projected points **123,** analysis tool **104** computes distance data **110.** Distance data **110** includes a distance between each corresponding point pair (sample point-projected point pair) from sample points **122** and projected points **123.** Distance data **110** thus provides information based on model **112** of structure **101** that can be used for verifying and/or analyzing sensor data **106** generated by sensor system **102.**

For example, sensor data **106** may be compared to distance data **110** to determine whether any actual distances between surfaces of structure **101** are outside of the selected tolerances from the designed distances, as identified by distance data **110.** Such differences may signal the detection of one or more inconsistencies in structure **101.**

In one or more examples, analysis tool **104** generates function **126** using distance data **110.** Function **126** enables identifying the designed distance between surfaces (e.g., a design thickness) to be computed at other points along outer surface **114** beyond sample points **122.** For example, function **126** may be a continuous function that enables a distance between outer surface **114** and inner surface **118** to be generated for any point along outer surface **114,** including those points not included in sample points **122.**

In some cases, function **126** may be output from analysis tool **104** to another computing platform (e.g., a cloud computing platform, another computer system, etc.) to enable one or more different users to use function **126** to compute designed distances. Depending on its implementation, function **126** may be alternatively referred to as a distance function or a thickness function.

Although distance data **110** has been described as being generated for a single scan surface **120,** distance data **110** may include data generated for multiple scan surfaces. For example, model **112** may be divided into various inspection areas (or inspection zones). Distance data **110** may include data generated for each of these various inspection areas such that data is generated for the entire structure **101.**

In some examples, analysis tool **104** generates visualization output **128** of distance data **110.** Visualization output **128** may be sent to, for example, display device **130** for display to a user. Visualization output **128** may take different forms. In one or more examples, visualization output **128** takes the form of a three-dimensional distance map or distance model that visually presents at least a portion of distance data **110.** In one or more examples, visualization output **128** is a thickness map or thickness model that visually presents thicknesses.

The block diagram of **Figure 1** is not meant to imply physical or architectural limitations to the manner in which an example embodiment may be implemented. Other components in addition to or in place of the ones illustrated may be used. Some components may be optional. Further, the blocks are presented to illustrate functional components. One or more of these blocks may be combined, divided, or combined and divided into different blocks when implemented in an example embodiment.

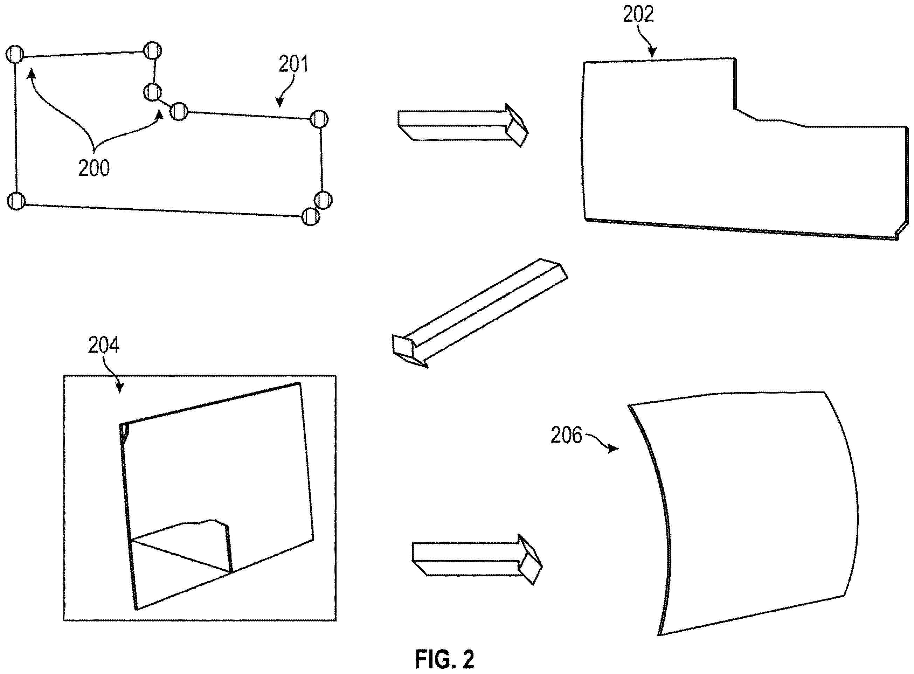

**Figures 2-6** are illustrations that describe different steps that may be involved in the generation of distance data, such as distance data **110** in **Figure 1****.** **Figures 2-6** are thus described with continuing reference to **Figure 1****.**

**Figure 2** is a schematic diagram of a process for generating a scan surface in accordance with one or more example embodiments. In particular, the process illustrated in **Figure 2** may be implemented by analysis tool **104** in **Figure 1****.**

Coordinates **200** are first identified. Coordinates **200** may define an area of structure **101** that has been or is to be inspected or "scanned" using sensor system **102** in **Figure 1****.** For example, coordinate **200** may define inspection area **121** of structure **101** in **Figure 1****.** Coordinates **200** are on a reference coordinate system. This reference coordinate system may be, for example, the coordinate system of model **112** of structure **101** in **Figure 1****.**

In one or more examples, coordinates **200** are identified from input **111** in **Figure 1****.** For example, input **111** may include coordinates **200** extracted from or a program that is used to control sensor system **102** and move sensor system **102** along structure **101.** In some cases, input **111** may include the program itself and analysis tool **104** may identify coordinates **200** from the program.

In other examples, input **111** includes user input that identifies coordinates **200.** In some cases, input **111** includes data received from sensor system **102** that identifies coordinates **200.** In yet other examples, analysis tool **104** may receive input **111** that includes initial coordinates corresponding to a different coordinate system. Analysis tool **104** processes these initial coordinates (e.g., transforms the initial coordinates) to generate coordinates **200** on the reference coordinate system.

Coordinates **200** are processed to identify initial surface **202,** which represents inspection area **121** in **Figure 1****.** In particular, coordinates **200** are used to identify boundary **201** for use in defining initial surface **202.** Initial surface **202** may be represented in the three-dimensional domain.

In some cases, when processed with respect to the two-dimensional domain, one or more portions of boundary **201** for initial surface **202** may be formed by one or more convex curves, concave curves, or both. To reduce the processing time associated with initial surface **202** having this type of boundary **201,** convex shape **204** may be generated for initial surface **202** in the two-dimensional domain. Convex shape **204** includes one or more local convex hulls that ensure that initial surface **202** is fully or generally contained within convex shape **204.** In this manner, convex shape **204** may be convex or nearly convex. In one or more examples, convex shape **204** is generated such that boundary **201** for initial surface **202** is entirely overlapped with or contained within convex shape **204.**

Scan surface **206** is then generated in the three-dimensional domain based on convex shape **204.** Scan surface **206** is one example of an implementation for scan surface **120** in **Figure 1****.** Scan surface **206** has a substantially convex shape or boundary. As used herein, "substantially convex" means convex or nearly convex. In one or more examples, scan surface **206** represents the global convex or nearly convex shape for inspection area **121.** In these examples, scan surface **206** corresponds to the same reference coordinate system as initial surface **202.**

In other cases, boundary **201** of initial surface **202** may itself be substantially convex. Accordingly, initial surface **202** may be used as scan surface **206.** In some examples, initial surface **202** is used as scan surface **206** when the shape of boundary **201** is sufficiently simple so as to not increase the amount of processing time or resources needed more than desired.

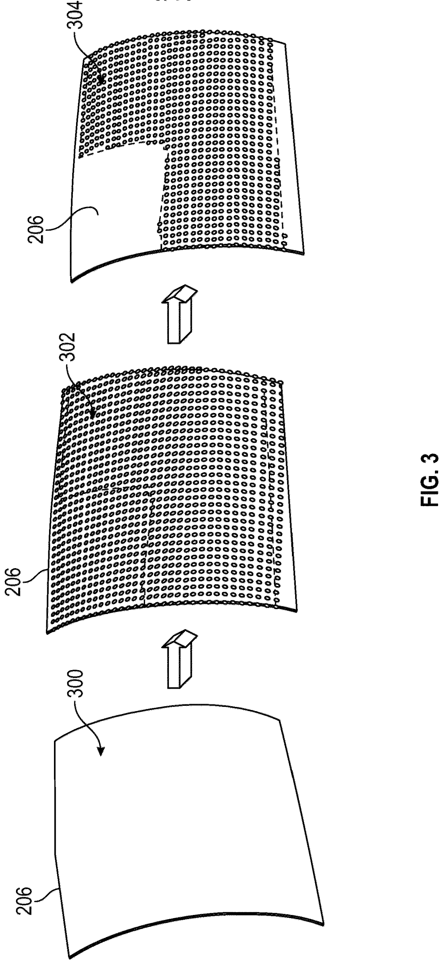

**Figure 3** is schematic diagram of a process for generating a plurality of sample points on scan surface **206** from **Figure 2** in accordance with one or more example embodiments. In particular, the process illustrated in **Figure 3** may be implemented by analysis tool **104** in **Figure 1****.**

First, a plurality of reference curves **300** are identified along scan surface **206.** Each of reference curves **300** represents a path along which sensor system **102** is moved within inspection area **121** in **Figure 1** to inspect or "scan" structure **101.** In one or more examples, reference curves **300** are generated based on the same portion of input **111** from which coordinates **200** in **Figure 2** are identified. In other examples, reference curves **300** are generated based on another portion of input **111** received at analysis tool **104.**

Reference curves **300** may be equally spaced apart. For example, input **111** may identify a first reference curve (e.g., a spine curve). Analysis tool **104** uses this first reference curve to generate additional reference curves that are parallel to this first reference curve and equally spaced apart with respect to each other. In other examples, not all of reference curves **300** may be equally spaced.

A collection of points **302** along scan surface **206** are then identified using reference curves **300** and a spacing distance. Each of points **302** may be defined in three dimensions (e.g., an x-y-z point). Points **302** may be spaced apart along each of reference curves **300** according to the spacing distance. This spacing distance may be provided by input **111.** In some examples, this spacing distance is provided by the same portion of input **111** from which coordinates **200** in **Figure 2****,** reference curves **300,** or both are generated. In other examples, the spacing distance is provided by another portion of input **111.**

A plurality of scan points **304** are selected from points **302** based on initial surface **202,** boundary **201,** or both in **Figure 2****.** Scan points **304** are those ones of points **302** that are fully contained within boundary **201** or that overlap with initial surface **202** if initial surface **202** were to be superimposed or overlaid over scan surface **206.** Scan points **304** may be projected onto an outer surface, such as outer surface **114** in **Figure 1****,** to generate sample points **122** in **Figure 1****.**

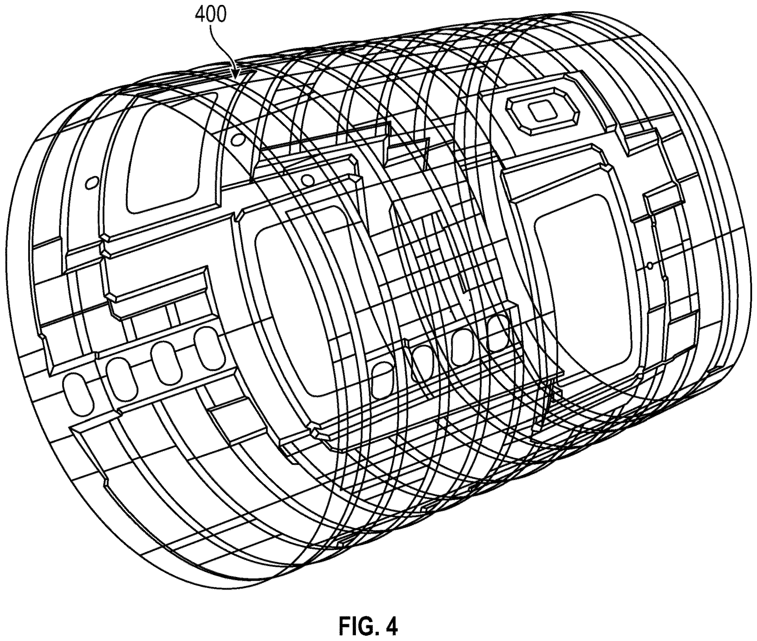

**Figure 4** is a schematic diagram of a geometric representation that has been generated using model **112** of structure **101** in **Figure 1** in accordance with one or more example embodiments. Geometric representation **400** may be generated for one of surfaces **133** identified from model **112** in **Figure 1****.** In the illustrated example, geometric representation **400** is generated for outer surface **114** in **Figure 1****.**

Geometric representation **400** comprises a plurality of patches **402.** As used herein, a "patch" is a geometric representation of a portion of or a section of a corresponding surface. In some cases, a patch may also be referred to as a surface path. This abstract geometric representation may have a curved shape, a polygonal shape, an irregular shape, or some other type of shape. In one or more examples, patches **402** may have the same shape and size (e.g., the same polygonal shape to form a polygonal mesh) or may have different shapes, different sizes, or both. A patch may be alternatively referred to as a "face," a "surface section." In some examples, geometric representation **400** is referred to as a patched or patch-based representation.

Analysis tool **104** in **Figure 1** may sample patches **402** to identify at least one patch point in each of patches **402.** This sampling may be performed in order to build at least one k-dimensional tree that organizes these patch points in the three-dimensional domain.

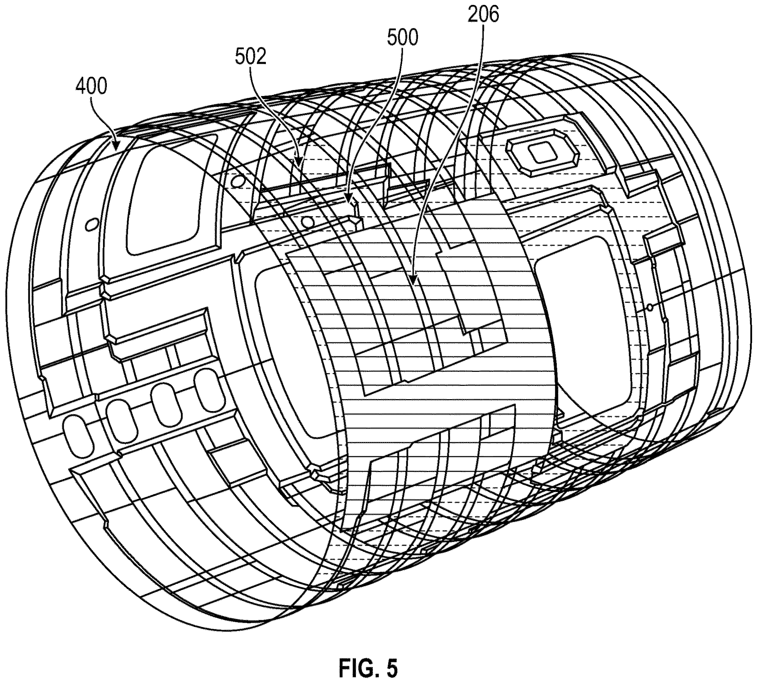

**Figure 5** is a schematic diagram of a relevant surface area that has been identified from geometric representation **400** in **Figure 4** in accordance with one or more example embodiments. Relevant surface area **500** includes selected portion **502** of patches **402** from **Figure 4** that have been determined to overlap with, coincide with, and/or be in close proximity to scan surface **206** if scan surface **206** were aligned with or superimposed over geometric representation **400** in **Figure 4****.** Thus, relevant surface **500** corresponds to the surface (e.g., outer surface **114**) from which geometric representation **400** is created by representing the portion of that surface most relevant scan surface **206.**

The one or more k-dimensional trees generated for geometric representation **400** are used to narrow down patches **402** and identify relevant surface area **500.** Relevant surface area **500** provides a more focused space from which to identify sample points **122** in **Figure 1****.** Using relevant surface area **500** to generate sample points **122** may reduce the overall amount of processing time needed and the amount of processing resources used to generate distance data **110.** Although relevant surface area **500** has been described as being generated using k-dimensional trees, in other examples, some other type of technique for accelerating the process of identifying relevant surface area **500** may be used.

Although geometric representation **400** in **Figure 4** and relevant surface area **500** are described with respect to outer surface **114** in **Figure 1****,** similar steps may be performed for each inner surface of set of inner surfaces **116** in **Figure 1****.** For example, similar steps may be used to generate projected points **123** in **Figure 1****.**

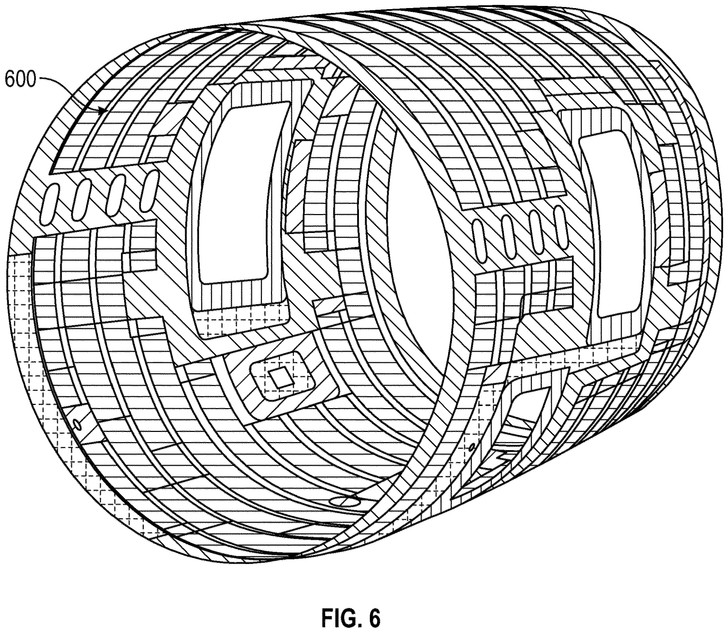

**Figure 6** is an illustration of a thickness map in accordance with one or more example embodiments. Thickness map **600** is one example of an implementation for visualization output **128** in **Figure 1****.** Thickness map **600** is a three-dimensional mapping of distance data **110** computed for fuselage structure **103** in **Figure 1****.** In one or more examples, thickness map **600** is color-coded to provide a visualization of different ranges of thicknesses for fuselage structure **103.**

In other examples, thickness map **600** may provide a different type of visual indication of the different ranges of thicknesses for fuselage structure **103.** For example, different shades of a single color may be used. As another example, different patterns may be used.

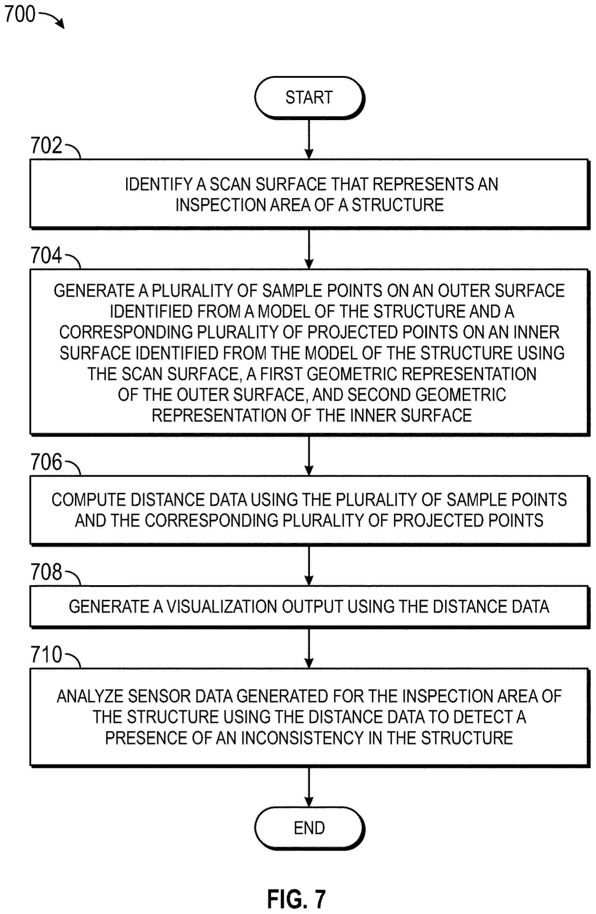

**Figure 7** is a flowchart of a process for inspecting a structure in accordance with one or more example embodiments. Process **700** in **Figure 7** may be implemented using analysis tool **104** in **Figure 1****.**

Process **700** begins by identifying a scan surface that represents an inspection area of a structure (operation **702**). The structure may be, for example, structure **101** in **Figure 1****.** In one or more examples, the structure takes the form of fuselage structure **103** in **Figure 1****.** In other examples, the structure may be another type of aircraft structure (e.g., a wing structure, a tail section, a nose section, a control surface structure, etc.). The inspection area of the structure may be, for example, inspection area **121** in **Figure 1****.** The scan surface may be, for example, scan surface **120** in **Figure 1****.** In one or more examples, the scan surface may have a substantially convex shape.

A plurality of sample points on an outer surface identified from a model of the structure and a corresponding plurality of projected points on an inner surface identified from the model of the structure are generated using the scan surface, a first geometric representation of the outer surface, a second geometric representation of the inner surface, and a spatial indexing algorithm (operation **704**). The plurality of sample points and the corresponding plurality of projected points may be, for example, sample points **122** and projected points **123** in **Figure 1****,** respectively.

Distance data is computed using the plurality of sample points and the corresponding plurality of projected points (operation **706**). The distance data may be, for example, distance data **110** in **Figure 1****.** Optionally, process **700** may further include generating a visualization output using the distance data (operation **708**). This visualization output, which may be visualization output **128** in **Figure 1****,** may take a number of different forms. For example, the visualization output may include one or more two-dimensional distance maps, one or more three-dimensional distance maps, or a combination thereof.

Sensor data generated for the inspection area of the structure is analyzed using the distance data to detect a presence of an inconsistency in the structure (operation **710**), with the process terminating thereafter. The sensor data may be, for example, sensor data **106** in **Figure 1****.** In one or more examples, the distance data includes a distance between each corresponding point pair from the plurality of sample points and the corresponding plurality of projected points. In other words, the distance data includes a distance for each corresponding sample point-projected point pair.

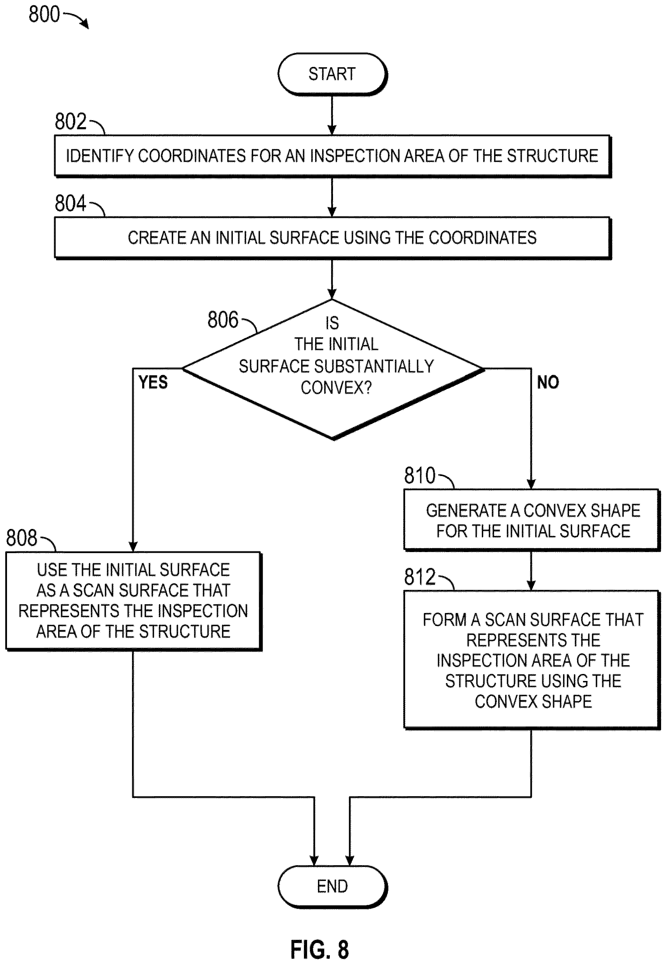

**Figure 8** is a flowchart of a process for identifying a scan surface in accordance with one or more example embodiments. Process **800** in **Figure 8** may be implemented using analysis tool **104** in **Figure 1****.** Further, process **800** may be one example of a manner in which operation **702** in **Figure 7** may be implemented.

Process **800** begins by identifying coordinates for an inspection area of the structure (operation **802**). Coordinates **200** in **Figure 2** may be one example of an implementation for the coordinates identified in operation **802.** The coordinates may be received in user input, identified from a program, or identified in some other manner.

Thereafter, an initial surface is created using the coordinates (operation **804**). The initial surface is three-dimensional. Initial surface **202** in **Figure 2** is one example of an implementation for the initial surface created in operation **804.**

A determination is made as to whether the initial surface is substantially convex (operation **806**). If the initial surface is substantially convex (i.e., substantially contained within a convex shape), the initial surface is used as a scan surface that represents the inspection area of the structure (operation **808**), with the process terminating thereafter.

Otherwise, a convex shape is generated for the initial surface (operation **810**). The convex shape includes one or more local convex hulls that ensure that the initial surface **202** is fully contained within the convex shape. This convex shape is substantially convex. In one or more examples, the convex shape is generated in the two-dimensional domain. Convex shape **204** in **Figure 2** is one example of an implementation for the convex shape generated in operation **810.**

A scan surface that represents the inspection area of the structure is formed using the convex shape (operation **812**). In one or more examples, operation **812** may include transforming the convex shape from the two-dimensional domain into the three-dimensional domain to form the scan surface. Scan surface **206** in **Figure 2** is one example of an implementation for the scan surface generated in operation **812.**

**Figure 9** is a flowchart of a process for generating sample points in accordance with one or more example embodiments. Process **900** in **Figure 9** may be implemented using analysis tool **104** in **Figure 1****.** Further, process **900** may be one example of a manner in which at least a portion of operation **704** in **Figure 7** may be implemented.

Process **900** may begin by identifying a relevant surface area that represents a portion of an outer surface that corresponds to a scan surface (operation **902**). Relevant surface area **500** in **Figure 5** is one example of an implementation for the relevant surface area identified in operation **902.** When the structure is a fuselage structure, the outer surface may be an outer mold line of the fuselage structure. The outer surface may be identified from a model of the structure.

Scan points are identified on a scan surface that represents an inspection area of the structure (operation **904**). The scan surface may be, for example, scan surface **120** in **Figure 1****.** The scan surface may be generated using, for example, process **800** in **Figure 8****.**

A scan point is selected for processing (operation **906**). The relevant surface area is processed to identify a patch of the relevant surface area that is nearest the selected scan point (operation **908**). Operation **908** may be performed using, for example, one or more k-dimensional trees built for the relevant surface area, built for the inner surface, or both.

A sample point is formed using a point on the patch that intersects with a vector that is substantially normal to the scan surface at a location of the selected scan point (operation **910**). In one or more examples, operation **910** may be performed by identifying the point on the patch that has a minimum distance to the selected scan point as the sample point. In some cases, this sample point is selected from a collection of sampling of points generated for the patch.

A determination is made as to whether any unprocessed scan points remain (operation **912**). If any unprocessed scan points remain, process **900** returns to operation **906** described above. Otherwise, the process terminates.

**Figure 10** is a flowchart of a process for generating projected points in accordance with one or more example embodiments. Process **1000** in **Figure 10** may be implemented using analysis tool **104** in **Figure 1****.** Further, process **1000** may be one example of a manner in which at least a portion of operation **704** in **Figure 7** may be implemented.

Process **1000** may begin by begin by identifying a relevant surface area that represents a portion of an inner surface that corresponds to a scan surface (operation **1002**). This relevant area may be implemented in a manner similar to relevant surface area **500** in **Figure 5****.** The inner surface in operation **1002** may be, for example, inner surface **118** in **Figure 1****.** The inner surface may be identified from a model of a structure.

A sample point is selected for processing from a plurality of sample points (operation **1004**). The plurality of sample points may be, for example, the sample points generated by process **900** described above.

The relevant surface area is processed to identify a patch of the relevant surface area that is nearest the selected sample point (operation **1006**). A projected point is formed using a point on the patch that intersects with a vector that is substantially normal to the outer surface at a location of the selected sample point (operation **1008**). In one or more examples, operation **1008** may be performed by identifying the point within the patch corresponding to the inner surface that has a minimum distance to the sample point as the projected point. In some cases, this projected point is selected from a collection of sampling points generated for the patch.

A determination is made as to whether any unprocessed sample points remain (operation **1010**). If any unprocessed sample points remain, process **1000** returns to operation **1004** described above. Otherwise, the process terminates.

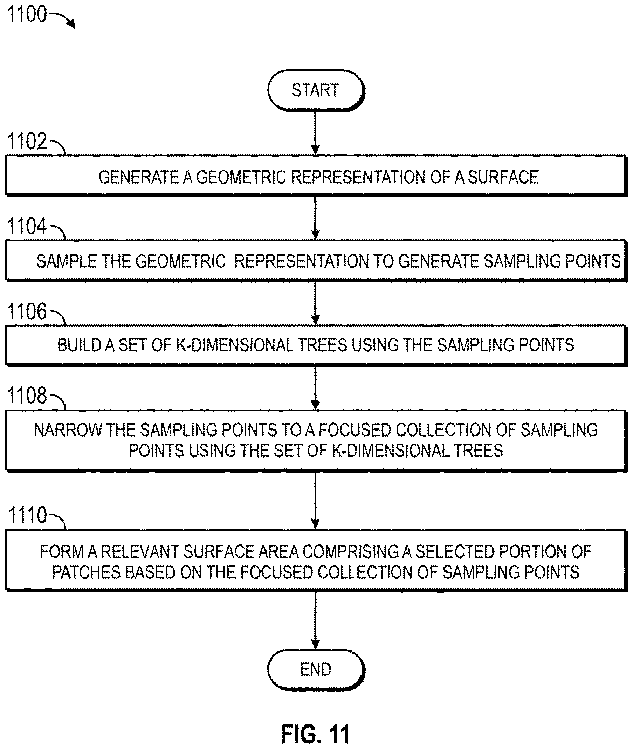

**Figure 11** is a flowchart of a process for identifying a relevant surface area for a surface in accordance with one or more example embodiments. Process **1100** in **Figure 11** may be implemented using analysis tool **104** in **Figure 1****.** Further, process **1100** may be one example of a manner in which operation **902** in **Figure 9** and operation **1002** in **Figure 10** may be implemented.

Process **1100** may begin by generate a geometric representation of a surface (operation **1102**). The geometric representation comprises a plurality of patches, each of these patches being an abstract geometric representation of a portion of the surface. Geometric representation **400** in **Figure 4** may be one example of an implementation for the geometric representation in operation **1102.**

Thereafter, the geometric representation is sampled to generate sampling points (operation **1104**). A set of k-dimensional trees is built using the sampling points (operation **1106**). The sampling points are narrowed to a focused collection of sampling points using the set of k-dimensional trees (operation **1108**). A relevant surface area comprising a selected portion of patches is formed based on the focused collection of sampling points (operation **1110**), with the process terminating thereafter. Although process **1100** is described using k-dimensional trees, in other examples, another type of spatial indexing algorithm may be used to perform operations **1106** and **1108** described above.

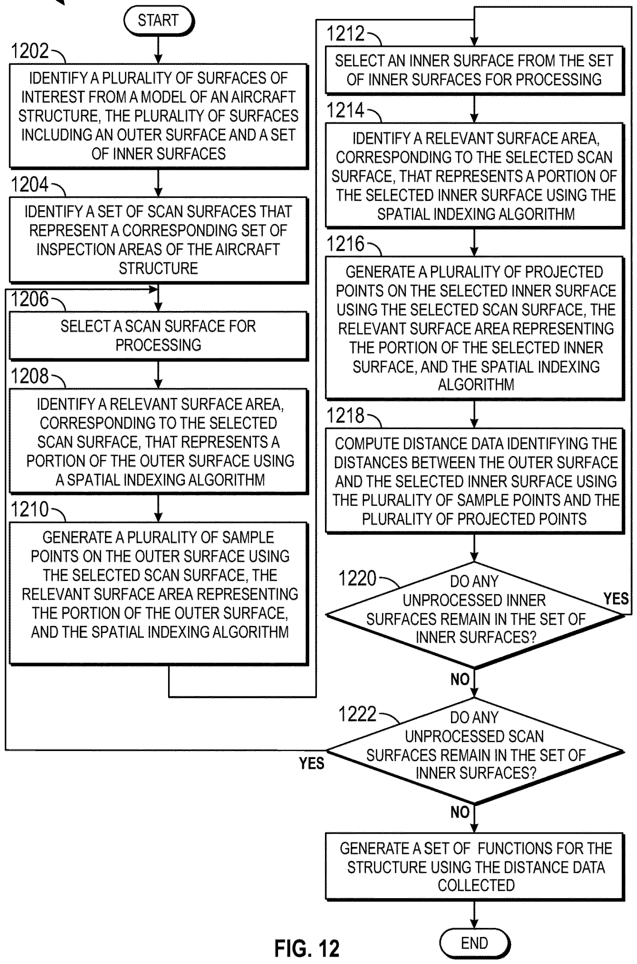

**Figure 12** is a flowchart of a process for generating a set of functions for a structure in accordance with one or more example embodiments. Process **1200** in **Figure 12** may be implemented using inspection system **100** in **Figure 1****.** As one example, process **1200** may be implemented using analysis tool **104** in **Figure 1****.** While process **1200** is described with respect to an aircraft structure, process **1200** may also be used with respect to other types of structures.

Process **1200** may begin by identifying a plurality of surfaces of interest from a model of an aircraft structure, the plurality of surfaces including an outer surface and a set of inner surfaces (operation **1202**). The aircraft structure may be a composite aircraft structure.

A set of scan surfaces that represent a corresponding set of inspection areas of the aircraft structure is identified (operation **1204**). For example, the aircraft structure may be a large fuselage structure for which multiple inspection areas (or zones) have been identified. A scan surface is identified for each of these different inspection areas. In one or more examples, these inspection areas are non-overlapping. In other examples, two or more of the inspection areas may at least partially overlap.

A scan surface is selected for processing (operation **1206**). A relevant surface area, corresponding to the selected scan surface, that represents a portion of the outer surface is identified using a spatial indexing algorithm (operation **1208**). The relevant surface area may comprise a portion of patches selected from a geometric representation of the outer surface. The relevant surface area corresponds to the selected scan surface by including those patches that would at least completely overlap with the selected scan surface if the selected scan surface were superimposed over the outer surface. The spatial indexing algorithm described in process **1200** may be, for example, spatial indexing algorithm **124** in **Figure 1****.**

A plurality of sample points on the outer surface are generated using the selected scan surface, the relevant surface area representing the portion of the outer surface, and the spatial indexing algorithm (operation **1210**).

An inner surface from the set of inner surfaces is selected for processing (operation **1212**). A relevant surface area, corresponding to the selected scan surface, that represents a portion of the selected inner surface is identified using the spatial indexing algorithm (operation **1214**). The relevant surface area may comprise a portion of patches selected from a geometric representation of the selected inner surface. The relevant surface area corresponds to the selected scan surface by including those patches that would at least completely overlap with the selected scan surface if the selected scan surface were superimposed over the selected inner surface.

A plurality of projected points on the selected inner surface are generated using the selected scan surface, the relevant surface area representing the portion of the selected inner surface, and the spatial indexing tree algorithm (operation **1216**).

Distance data identifying the distance between the outer surface and the selected inner surface is computed using the plurality of sample points and the plurality of projected points (operation **1218**). A determination is made as to whether any unprocessed inner surfaces remain in the set of inner surfaces (operation **1220**). If any unprocessed inner surfaces remain, process **1200** returns to operation **1212** described above. Otherwise, a determination is made as to whether any unprocessed scan surfaces remain in the set of scan surfaces (operation **1222**). If any unprocessed scan surfaces remain, process **1200** returns to operation **1206** described above.

Otherwise, the distance data collected is used to generate a set of functions for the structure (operation **1224**). In one or more examples, each function of the set of functions may be a continuous function. In operation **1222,** each function of the set of functions may correspond to a different inner surface of the set of inner surfaces. Each function may be used to identify an as-designed distance between the outer surface and the corresponding inner surface at any point along the outer surface.

With respect to operations **1208** and **1210,** generating the relevant surface area representing the portion of the outer surface corresponding to each scan surface of the set of scan surfaces reduces the overall processing time and processing resources needed to generate the sample points for each scan surface. Similarly, with respect to operations **1214** and **1216,** generating the relevant surface representing the portion of each inner surface of the set of inner surfaces corresponding to a selected scan surface reduces the overall processing time and processing resources needed to generate the projected points for each inner surface.

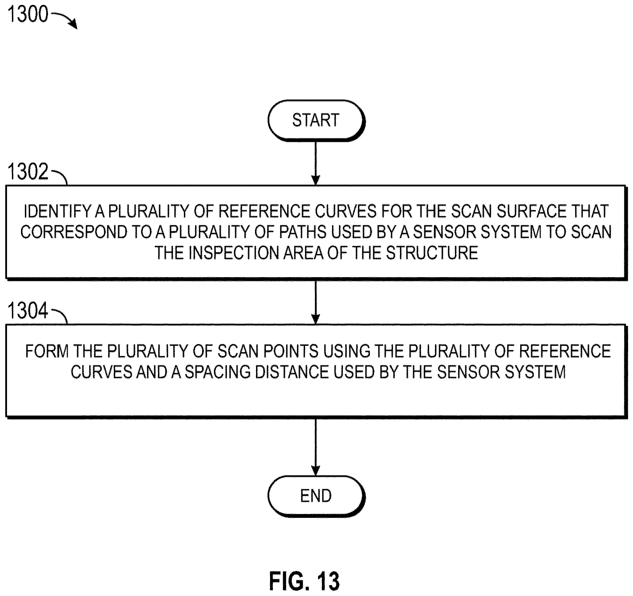

**Figure 13** is a flowchart of a process for identifying a plurality of scan points in accordance with one or more example embodiments. Process **1300** in **Figure 13** may be implemented using analysis tool **104** in **Figure 1****.** Process **1300** may be one example of a manner in which operation **904** in **Figure 9** may be implemented.

Process **1300** may begin by identifying a plurality of reference curves for the scan surface that correspond to a plurality of paths used by a sensor system to scan the inspection area of the structure (operation **1302**). In operation **1302,** the plurality of reference curves may be identified based on a program that was used or is to be used to control the sensor system. In one or more examples, the reference curves are substantially parallel to each other and equally spaced apart. As used herein, "substantially parallel" means parallel or nearly parallel. The sensor system in operation **1302** may be, for example, sensor system **102** in **Figure 1****.**

Next, a plurality of scan points are formed using the plurality of reference curves and a spacing distance used by the sensor system (operation **1304**), with the process terminating thereafter. The spacing distance provides the distance for scan points identified along a same reference curve.

Operation **1304** may be performed in various ways. In one or more examples, operation **1304** includes identifying points along each reference curve of the plurality of reference curves based on the spacing distance to form a collection of points. Operation **1304** may further include selecting a portion of the collection of points that falls within a boundary corresponding to the inspection area to form the plurality of scan points.

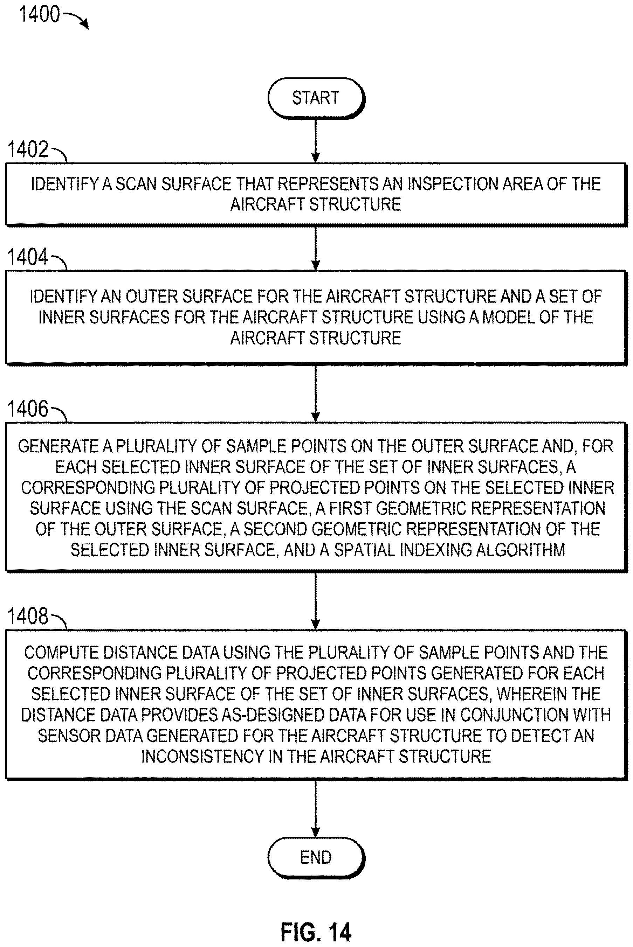

**Figure 14** is a flowchart of a process for computing distance data for an aircraft structure in accordance with one or more example embodiments. Process **1400** in **Figure 14** may be implemented using analysis tool **104** in **Figure 1****.** While process **1400** is described with respect to an aircraft structure, process **1400** may also be used with respect to other types of structures, including various types of composite structures.

Process **1400** may begin by identifying a scan surface that represents an inspection area of the aircraft structure (operation **1402**). An outer surface for the aircraft structure and a set of inner surfaces for the aircraft structure are identified using a model of the aircraft structure (operation **1404**) .

Thereafter, a plurality of sample points on the outer surface and, for each selected inner surface of the set of inner surfaces, a corresponding plurality of projected points on the selected inner surface are generated using the scan surface, a first geometric representation of the outer surface, a second geometric representation of the selected inner surface, and a spatial indexing algorithm (operation **1406**). Using the spatial indexing algorithm may help speed up processing. In one or more examples, the spatial indexing algorithm uses one or more k-dimensional trees to provide indexing for the first geometric representation and the second geometric representation.

Distance data is computed using the plurality of sample points and the corresponding plurality of projected points generated for each selected inner surface of the set of inner surfaces, wherein the distance data provides as-designed data for use in conjunction with sensor data generated for the aircraft structure to detect an inconsistency in the aircraft structure (operation **1408**), with the process terminating thereafter. In some examples, operation **1408** includes generating a function (e.g., a continuous function) for each pairing of the outer surface and an inner surface of the set of inner surfaces.

This function, which may be, for example, function **126** in **Figure 1****,** may be used to quickly and reliably identify the as-designed distance between the outer surface and the particular inner surface for any location on the outer surface. This as-designed distance may be compared to measurements generated by a sensor system for the actual aircraft structure to evaluate whether the aircraft structure conforms with the design for the aircraft structure. Differences between the as-designed distances and the measurements generated by the sensor system that are outside of selected tolerances may indicate the presence of an inconsistency in the aircraft structure. The inconsistency may include a void, delamination, a crack, an undesired level of porosity, some other type of inconsistency, or a combination thereof.

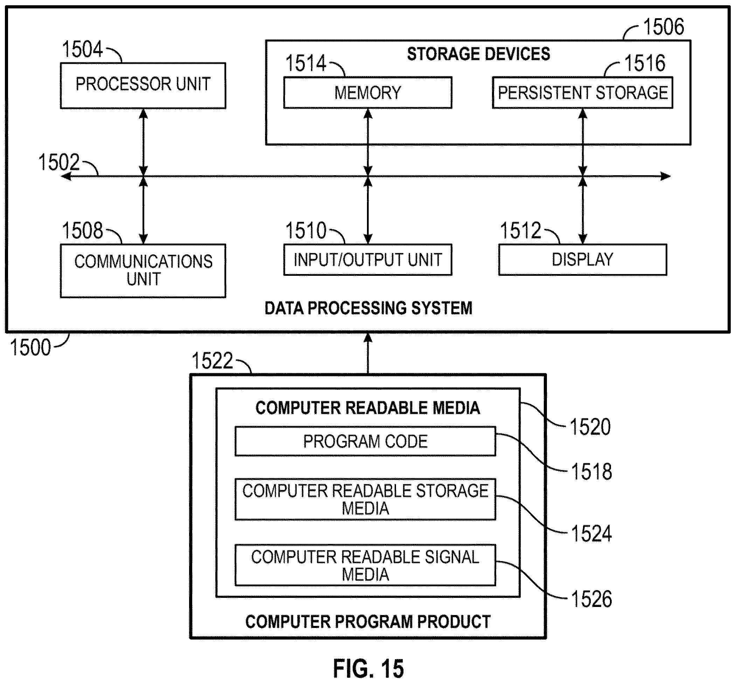

Turning now to **Figure 15****,** an illustration of a data processing system in the form of a block diagram is depicted in accordance with an example embodiment. Data processing system **1500** may be used to implement computer system **108** in **Figure 1****.** As depicted, data processing system **1500** includes communications framework **1502,** which provides communications between processor unit **1504,** storage devices **1506,** communications unit **1508,** input/output unit **1510,** and display **1512.** In some cases, communications framework **1502** may be implemented as a bus system.

Processor unit **1504** is configured to execute instructions for software to perform a number of operations. Processor unit **1504** may comprise a number of processors, a multi-processor core, and/or some other type of processor, depending on the implementation. In some cases, processor unit **1504** may take the form of a hardware unit, such as a circuit system, an application specific integrated circuit (ASIC), a programmable logic device, or some other suitable type of hardware unit.

Instructions for the operating system, applications, and/or programs run by processor unit **1504** may be located in storage devices **1506.** Storage devices **1506** may be in communication with processor unit **1504** through communications framework **1502.** As used herein, a storage device, also referred to as a computer readable storage device, is any piece of hardware capable of storing information on a temporary and/or permanent basis. This information may include, but is not limited to, data, program code, and/or other information.

Memory **1514** and persistent storage **1516** are examples of storage devices **1506.** Memory **1514** may take the form of, for example, a random access memory or some type of volatile or nonvolatile storage device. Persistent storage **1516** may comprise any number of components or devices. For example, persistent storage **1516** may comprise a hard drive, a flash memory, a rewritable optical disk, a rewritable magnetic tape, or some combination of the above. The media used by persistent storage **1516** may or may not be removable.

Communications unit **1508** allows data processing system **1500** to communicate with other data processing systems and/or devices. Communications unit **1508** may provide communications using physical and/or wireless communications links.

Input/output unit **1510** allows input to be received from and output to be sent to other devices connected to data processing system **1500.** For example, input/output unit **1510** may allow user input to be received through a keyboard, a mouse, and/or some other type of input device. As another example, input/output unit **1510** may allow output to be sent to a printer connected to data processing system **1500.**

Display **1512** is configured to display information to a user. Display **1512** may comprise, for example, without limitation, a monitor, a touch screen, a laser display, a holographic display, a virtual display device, and/or some other type of display device.

In one or more examples, the processes of the different example embodiments may be performed by processor unit **1504** using computer-implemented instructions. These instructions may be referred to as program code, computer usable program code, or computer readable program code and may be read and executed by one or more processors in processor unit **1504.**

In these examples, program code **1518** is located in a functional form on computer readable media **1520,** which is selectively removable, and may be loaded onto or transferred to data processing system **1500** for execution by processor unit **1504.** Program code **1518** and computer readable media **1520** together form computer program product **1522.** In one or more examples, computer readable media **1520** may be computer readable storage media **1524** or computer readable signal media **1526.**

Computer readable storage media **1524** is a physical or tangible storage device used to store program code **1518** rather than a medium that propagates or transmits program code **1518.** Computer readable storage media **1524** may be, for example, without limitation, an optical or magnetic disk or a persistent storage device that is connected to data processing system **1500.**

Alternatively, program code **1518** may be transferred to data processing system **1500** using computer readable signal media **1526.** Computer readable signal media **1526** may be, for example, a propagated data signal containing program code **1518.** This data signal may be an electromagnetic signal, an optical signal, and/or some other type of signal that can be transmitted over physical and/or wireless communications links.

The illustration of data processing system **1500** in **Figure 15** is not meant to provide architectural limitations to the manner in which the example embodiments may be implemented. The different example embodiments may be implemented in a data processing system that includes components in addition to or in place of those illustrated for data processing system **1500.** Further, components shown in **Figure 15** may be varied from the examples shown.

Example embodiments of the disclosure may be described in the context of aircraft manufacturing and service method **1600** as shown in **Figure 16** and aircraft **1700** as shown in **Figure 17****.** Turning first to **Figure 16****,** an illustration of an aircraft manufacturing and service method is depicted in accordance with an example embodiment. During pre-production, aircraft manufacturing and service method **1600** may include specification and design **1602** of aircraft **1700** in **Figure 17** and material procurement **1604.**

During production, component and subassembly manufacturing **1606** and system integration **1608** of aircraft **1700** in **Figure 17** takes place. Thereafter, aircraft **1700** in **Figure 17** may go through certification and delivery **1610** in order to be placed in service **1612.** While in service **1612** by a customer, aircraft **1700** in **Figure 17** is scheduled for routine maintenance and service **1614,** which may include modification, reconfiguration, refurbishment, and other maintenance or service.

Each of the processes of aircraft manufacturing and service method **1600** may be performed or carried out by a system integrator, a third party, and/or an operator. In these examples, the operator may be a customer. For the purposes of this description, a system integrator may include, without limitation, any number of aircraft manufacturers and majorsystem subcontractors; a third party may include, without limitation, any number of vendors, subcontractors, and suppliers; and an operator may be an airline, a leasing company, a military entity, a service organization, and so on.

With reference now to **Figure 17****,** an illustration of an aircraft is depicted in which an example embodiment may be implemented. In this example, aircraft **1700** is produced by aircraft manufacturing and service method **1600** in **Figure 16** and may include airframe **1702** with plurality of systems **1704** and interior **1706.** Examples of systems **1704** include one or more of propulsion system **1708,** electrical system **1710,** hydraulic system **1712,** and environmental system **1714.** Any number of other systems may be included. Although an aerospace example is shown, different example embodiments may be applied to other industries, such as the automotive industry.

Apparatuses and methods embodied herein may be employed during at least one of the stages of aircraft manufacturing and service method **1600** in **Figure 16****.** In particular, fabrication system **164** from **Figure 1** may be used to fabricate tool **162** during any one of the stages of aircraft manufacturing and service method **1600.** For example, without limitation, inspection system **100,** sensor system **102,** or analysis tool **104** from **Figure 1** may be used during at least one of component and subassembly manufacturing **1606,** system integration **1608,** certification and delivery **1610,** routine maintenance and service **1614,** or some other stage of aircraft manufacturing and service method **1600.** Still further, inspection system **100** may be used to inspect one or more aircraft structures of aircraft **1700** such as, but not limited to, one or more structures of airframe **1702,** interior **1706,** or both of aircraft **1700** in **Figure 17****.** Analysis tool **104** in **Figure 1** may be used to compute distance data **110** for these aircraft structures of aircraft **1700.**

In one or more example, components or subassemblies produced in component and subassembly manufacturing **1606** in **Figure 16** may be fabricated or manufactured in a manner similar to components or subassemblies produced while aircraft **1700** is in service **1612** in **Figure 16****.** As yet another example, one or more apparatus embodiments, method embodiments, or a combination thereof may be utilized during production stages, such as component and subassembly manufacturing **1606** and system integration **1608** in **Figure 16****.** One or more apparatus embodiments, method embodiments, or a combination thereof may be utilized while aircraft **1700** is in service **1612** and/or during maintenance and service **1614** in **Figure 16****.** The use of a number of the different example embodiments may substantially expedite the assembly of and/or reduce the cost of aircraft **1700.** Further, one or more embodiments described herein may be used as part of propulsion system **1708** of aircraft **1700.**

The flowcharts and block diagrams in the different depicted embodiments illustrate the architecture, functionality, and operation of some possible implementations of apparatuses and methods in an example embodiment. In this regard, each block in the flowcharts or block diagrams may represent a module, a segment, a function, and/or a portion of an operation or step.

In some alternative implementations of an example embodiment, the function or functions noted in the blocks may occur out of the order noted in the figures. For example, in some cases, two blocks shown in succession may be executed substantially concurrently, or the blocks may sometimes be performed in the reverse order, depending upon the functionality involved. Also, other blocks may be added in addition to the illustrated blocks in a flowchart or block diagram.

As used herein, the phrase "at least one of," when used with a list of items, means different combinations of one or more of the listed items may be used and only one of the items in the list may be needed. The item may be a particular object, thing, step, operation, process, or category. In other words, "at least one of" means any combination of items or number of items may be used from the list, but not all of the items in the list may be required. For example, without limitation, "at least one of item A, item B, or item C" or "at least one of item A, item B, and item C" may mean item A; item A and item B; item B; item A, item B, and item C; item B and item C; or item A and C. In some cases, "at least one of item A, item B, or item C" or "at least one of item A, item B, and item C" may mean, but is not limited to, two of item A, one of item B, and ten of item C; four of item B and seven of item C; or some other suitable combination.

The description of the different example embodiments has been presented for purposes of illustration and description, and is not intended to be exhaustive or limited to the embodiments in the form disclosed. Many modifications and variations will be apparent to those of ordinary skill in the art within the scope of the appended claims. Further, different example embodiments may provide different features as compared to other desirable embodiments. The embodiment or embodiments selected are chosen and described in order to best explain the principles of the embodiments, the practical application, and to enable others of ordinary skill in the art to understand the disclosure for various embodiments with various modifications as are suited to the particular use contemplated.

## Claims

1. A computer-implemented method for inspecting a structure (101), the method comprising:
identifying (702) a scan surface (120) that represents an inspection area (121) of the structure (101);
generating (704) a plurality of sample points (122) on an outer surface (114) identified from a model (112) of the structure (101) and a corresponding plurality of projected points (123) on an inner surface (118) identified from the model (112) of the structure (101) using the scan surface (120, a first geometric representation (400) of the outer surface (114), and a second geometric representation of the inner surface (118);
computing (706) distance data (110) using the plurality of sample points (122) and the corresponding plurality of projected points (123), the distance data (110) including a distance between each corresponding point pair (sample point-projected point pair) from sample points (122) and projected points (123); and
analyzing (710) sensor data (106) generated for the inspection area (121) of the structure (101) using the distance data (110) to detect a presence of an inconsistency in the structure (101).

2. The method of claim 1, further comprising:
generating (708) a visualization output (128) of the distance data (110) (702), or optionally generating (1224) a function (126) using the distance data (110) that enables a distance between the outer surface (114) and the inner surface (118) to be computed via the function (126) at any selected point along the outer surface (114).

3. The method of **any of claims 1-2,** wherein identifying (702) the scan surface (120) comprises:
identifying (802) coordinates (200) for the inspection area (121) of the structure (101);
creating (804) an initial surface (202) using the coordinates (200);
generating (810) a convex shape (204) for the initial surface (202); and
forming (812) the scan surface (120) using the convex shape (204) such that the scan surface (120) has a substantially convex shape.

4. The method of claim 3, wherein generating (704) the plurality of sample points (122) on the outer surface (114) further comprises:
identifying (904) a plurality of scan points (304) on the scan surface;
processing (908), for each selected scan point of the plurality of scan points (304), the relevant surface area to identify a patch of the relevant surface area that is nearest the selected scan point; and
forming (910), for each selected scan point of the plurality of scan points (304), a sample point of the plurality of sample points (122) using a point on the patch that intersects with a vector that is substantially normal to the scan surface (120) at a location of the selected scan point.

5. The method of claim 4, wherein identifying (904) the plurality of scan points (304) comprises:
identifying (1302) a plurality of reference curves for the scan surface (120) corresponding to a plurality of paths used by a sensor system (102) to scan the inspection area (121) of the structure (101); and
forming (1304) the plurality of scan points (304) using the plurality of reference curves and a spacing distance used by the sensor system (102).

6. The method of claim 5, wherein forming (1304) the plurality of scan points (304) comprises:
identifying points along each reference curve of the plurality of reference curves based on the spacing distance to form a collection of points; and
selecting a portion of the collection of points that falls within a boundary corresponding to the inspection area (121) to form the plurality of scan points (304).

7. The method of claim 3, wherein identifying (902) the relevant surface area comprises:
generating (1102) the first geometric representation of the outer surface (114), the first geometric representation comprising a plurality of patches;
sampling (1104) the first geometric representation to generate sampling points;
narrowing (1108) the sampling points to a focused collection of sampling points using a spatial indexing algorithm (124); and
forming (1110) the relevant surface area based on the focused collection of sampling points, the relevant surface area comprising a selected portion of the plurality of patches.

8. The method of any of claims 1-7, wherein generating (704) the corresponding plurality of projected points (123) on the inner surface (118) comprises:
identifying (1002) a relevant surface area that represents a portion of the inner surface (118) corresponding to the scan surface (120).

9. The method of claim 8, wherein generating (704) the corresponding plurality of projected points (123) on the inner surface (118) further comprises:
processing (1004), for each selected sample point of the plurality of sample points (122), the relevant surface area to identify a patch of the relevant surface area that is nearest the selected sample point; and
forming (1104), for each selected sample point of the plurality of sample points (122), a projected point using a point on the patch that intersects with a vector that is substantially normal to the outer surface (114) at a location of the selected sample point.

10. The method of claim 8, wherein identifying (1002) the relevant surface area comprises:
generating (1102) the second geometric representation of the inner surface (118), the second geometric representation comprising a plurality of patches;
sampling (1104) the second geometric representation to generate sampling points;
narrowing (1108) the sampling points to a focused collection of sampling points using a spatial indexing algorithm (124); and
forming (1110) the relevant surface area based on the focused collection of sampling points, the relevant surface area comprising a selected portion of the plurality of patches.

11. The method of any of claims 1-10, wherein the plurality of sampling points and the corresponding plurality of projected points (123) form a plurality of point pairs and wherein computing (706) the distance data (110) comprises: computing a distance between each point pair of the plurality of point pairs.

12. A system comprising:
a memory (1514) for storing a machine-readable medium comprising machine executable code; and
a processor (1504) coupled to the memory (1514) and configured to execute the machine executable code to cause the processor (1504) to implement an analysis tool (104) configured to:
identify a scan surface (120) that represents an inspection area (121) of a structure (101);
generate a plurality of sample points (122) on an outer surface (114) identified from a model (112) of the structure (101) and a corresponding plurality of projected points (123) on an inner surface (118) identified from the model (112) of the structure (101) using the scan surface, a first geometric representation of the outer surface (114), and a second geometric representation of the inner surface (118); and
compute distance data (110) using the plurality of sample points (122) and the corresponding plurality of projected points (123), wherein the distance data (110) identifies a distance between a point pair formed by a sample point of the plurality of sample points (122) and a projected point of the corresponding plurality of projected points (123); the system further comprising
a sensor system for generating sensor data; the analysis tool being further configured to analyze sensor data generated for the inspection area of the structure using the distance data to detect a presence of an inconsistency in the structure.

13. The system of claim 12, wherein the analysis tool is further configured to analyze the sensor data (106) generated for the inspection area (121) of the structure (101) using the distance data (110) to detect a presence of an inconsistency in the structure (101), or optionally wherein the analysis tool (104) is further configured to generate a visualization output of the distance data (110).

14. The system of claim 13, further comprising a display device, wherein the analysis tool (104) is further configured to display the visualization output on a display device, the visualization output comprising a thickness map.

15. The system of any of claims 12-14, wherein the analysis tool (104) is further configured to generate a function using the distance data (110) that enables a distance between the outer surface (114) and the inner surface (118) to be computed via the function at any selected point along the outer surface (114) .

## Patentansprüche

1. Computerimplementiertes Verfahren zum Prüfen einer Struktur (101), wobei das Verfahren umfasst:
Identifizieren (702) einer Scanfläche (120), die einen Prüfbereich (121) der Struktur (101) darstellt;
Generieren (704) einer Mehrzahl von Abtastpunkten (122) auf einer Außenfläche (114), die aus einem Modell (112) der Struktur (101) identifiziert wird, und einer entsprechenden Mehrzahl von Projektionspunkten (123) auf einer Innenfläche (118), die aus dem Modell (112) der Struktur (101) identifiziert wird, unter Verwendung der Scanfläche (120), einer ersten geometrischen Darstellung (400) der Außenfläche (114) und einer zweiten geometrischen Darstellung der Innenfläche (118);
Berechnen (706) von Abstandsdaten (110) unter Verwendung der Mehrzahl von Abtastpunkten (122) und der entsprechenden Mehrzahl von Projektionspunkten (13),
wobei die Abstandsdaten (110) einen Abstand zwischen jedem entsprechenden Punktepaar (Abtastpunkt-Projektionspunkt-Paar) von Abtastpunkten (122) und Projektionspunkten (123) umfassen; und
Analysieren (710) von Sensordaten (106), die für den Prüfbereich (121) der Struktur (101) generiert werden, unter Verwendung der Abstandsdaten (110), um das Vorhandensein einer Inkonsistenz in der Struktur (101) zu erkennen.

2. Verfahren nach Anspruch 1, ferner umfassend:
Generieren (708) einer Visualisierungsausgabe (128) der Abstandsdaten (110) (702) oder optionales Generieren (1224) einer Funktion (126) unter Verwendung der Abstandsdaten (110), die es ermöglicht, an jedem ausgewählten Punkt entlang der Außenfläche (114) einen Abstand zwischen der Außenfläche (114) und der Innenfläche (118) durch die Funktion (126) zu berechnen.

3. Verfahren nach einem der Ansprüche 1 bis 2, wobei das Identifizieren (702) der Scanfläche (120) umfasst:
Identifizieren (802) von Koordinaten (200) für den Prüfbereich (121) der Struktur (101);
Erzeugen (804) einer Ausgangsfläche (202) unter Verwendung der Koordinaten (200);
Generieren (810) einer konvexen Form (204) für die Ausgangsfläche (202); und
Bilden (812) der Scanfläche (120) unter Verwendung der konvexen Form (204), sodass die Scanfläche (120) eine im Wesentlichen konvexe Form aufweist.

4. Verfahren nach Anspruch 3, wobei das Erzeugen (704) der Mehrzahl von Abtastpunkten (122) auf der Außenfläche (114) ferner umfasst:
Identifizieren (904) einer Mehrzahl von Scanpunkten (304) auf der Scanfläche;
Verarbeiten (908) des relevanten Oberflächenbereichs für jeden ausgewählten Scanpunkt der Mehrzahl von Scanpunkten (304), um einen Patch des relevanten Oberflächenbereichs zu identifizieren, der dem ausgewählten Scanpunkt am nächsten ist; und
Bilden (910) eines Abtastpunkts der Mehrzahl von Abtastpunkten (122) für jeden ausgewählten Scanpunkt der Mehrzahl von Scanpunkten (304) unter Verwendung eines Punkts auf dem Patch, der sich mit einem Vektor schneidet, der an einer Position des ausgewählten Scanpunkts im Wesentlichen normal zur Scanoberfläche (120) ist.

5. Verfahren nach Anspruch 4, wobei das Identifizieren (904) der Mehrzahl von Scanpunkten (304) umfasst:
Identifizieren (1302) einer Mehrzahl von Bezugskurven für die Scanfläche (120), die einer Mehrzahl von Pfaden entspricht, die von einem Sensor zum Scannen des Prüfbereichs (121) der Struktur (101) verwendet wird; und
Bilden (1304) der Mehrzahl von Scanpunkten (304) unter Verwendung der Mehrzahl von Bezugskurven und einem Trennabstand, der vom Sensorsystem (102) verwendet wird.

6. Verfahren nach Anspruch 5, wobei das Bilden (1304) der Mehrzahl von Scanpunkten (304) umfasst:
Identifizieren von Punkten entlang jeder Bezugskurve der Mehrzahl von bezugskurven basierend auf dem Trennabstand, um eine Sammlung von Punkten zu bilden; und
Auswählen eines Teils der Sammlung von Punkten, der in eine Begrenzung fällt, die dem Prüfbereich (121) entspricht, um die Mehrzahl von Scanpunkten (304) zu bilden.

7. Verfahren nach Anspruch 3, wobei das Identifizieren (902) des relevanten Oberflächenbereichs umfasst:
Erzeugen (1102) der ersten geometrischen Darstellung der Außenfläche (114), wobei die erste geometrische Darstellung eine Mehrzahl von Patches umfasst;
Abtasten (1104) der ersten geometrischen Darstellung, um Abtastpunkte zu erzeugen;
Eingrenzen (1108) der Abtastpunkte auf eine fokussierte Sammlung von Abtastpunkten unter Verwendung eines räumlichen Indizierungsalgorithmus (124); und
Bilden (1110) des relevanten Oberflächenbereichs basierend auf der fokussierten Sammlung von Abtastpunkten, wobei der relevante Oberflächenbereich einen ausgewählten Teil der Mehrzahl von Patches umfasst.

8. Verfahren nach einem der Ansprüche 1 bis 7, wobei das Erzeugen (704) der entsprechenden Mehrzahl von Projektionspunkten (123) auf der Innenfläche (118) umfasst:
Identifizieren (1002) eines relevanten Oberflächenbereichs, der einen Teil der Innenfläche (118) darstellt, der der Scanfläche (120) entspricht.

9. Verfahren nach Anspruch 8, wobei das Erzeugen (704) der entsprechenden Mehrzahl von Projektionspunkten (123) auf der Innenfläche (118) ferner umfasst:
Verarbeiten (1004) des relevanten Oberflächenbereichs für jeden ausgewählten Abtastpunkt der Mehrzahl von Abtastpunkten (122), um einen Patch des relevanten Oberflächenbereichs zu identifizieren, der dem ausgewählten Abtastpunkt am nächsten ist; und
Bilden (1104) eines Projektionspunkts für jeden ausgewählten Abtastpunkt der Mehrzahl von Abtastpunkten (122) unter Verwendung eines Punkts auf dem Patch, der sich mit einem Vektor schneidet, der an einer Stelle des ausgewählten Abtastpunkts im Wesentlichen normal zur Außenfläche (114) ist.

10. Verfahren nach Anspruch 8, wobei das Identifizieren (1002) des relevanten Oberflächenbereichs umfasst:
Generieren (1102) der zweiten geometrischen Darstellung der Innenfläche (118), wobei die zweite geometrische Darstellung eine Mehrzahl von Patches umfasst;
Abtasten (1104) der zweiten geometrischen Darstellung, um Abtastpunkte zu generieren;
Eingrenzen (1108) der Abtastpunkte auf eine fokussierte Sammlung von Abtastpunkten unter Verwendung eines räumlichen Indizierungsalgorithmus (124); und
Bilden (1110) des relevanten Oberflächenbereichs basierend auf der fokussierten Sammlung von Abtastpunkten, wobei der relevante Oberflächenbereich einen ausgewählten Teil der Mehrzahl von Patches umfasst.

11. Verfahren gemäß einem der Ansprüche 1 bis 10, wobei die Mehrzahl von Abtastpunkten und die entsprechende Mehrzahl von Projektionspunkten (123) eine Mehrzahl von Punktepaaren bilden und wobei das Berechnen (706) der Abstandsdaten (110) umfasst:
Berechnen eines Abstands zwischen jedem Punktepaar der Mehrzahl von Punktepaaren.

12. System, umfassend:
einen Speicher (1514) zum Speichern eines maschinenlesbaren Mediums mit maschinenausführbarem Code; und
einen Prozessor (1504), der mit dem Speicher (1514) gekoppelt und so konfiguriert ist, dass er den maschinenausführbaren Code ausführt, um den Prozessor (1504) zum Implementieren eines Analysetools (104) zu veranlassen, das konfiguriert ist zum:
Identifizieren einer Scanfläche (120), die einen Prüfbereich (121) der Struktur (101) darstellt;
Generieren einer Mehrzahl von Abtastpunkten (122) auf einer Außenfläche (114), die aus einem Modell (112) der Struktur (101) identifiziert wird, und einer entsprechenden Mehrzahl von Projektionspunkten (123) auf einer Innenfläche (118), die aus dem Modell (112) der Struktur (101) identifiziert wird, unter Verwendung der Scanfläche, einer ersten geometrischen Darstellung der Außenfläche (114) und einer zweiten geometrischen Darstellung der Innenfläche (118); und
Berechnen von Abstandsdaten (110) unter Verwendung der Mehrzahl von Abtastpunkten (122) und der entsprechenden Mehrzahl von Projektionspunkten (123), wobei die Abstandsdaten (110) einen Abstand zwischen einem Punktepaar identifizieren, das durch einen Abtastpunkt der Mehrzahl von Abtastpunkten (122) und einen Projektionspunkt der Mehrzahl von Projektionspunkten (123) gebildet wird; wobei das System ferner umfasst:
ein Sensorsystem zum Generieren von Sensordaten; wobei das Analysetool ferner so konfiguriert ist, dass es für den Prüfbereich der Struktur generierte Sensordaten unter Verwendung der Abstandsdaten analysiert, um das Vorhandensein einer Inkonsistenz in der Struktur zu erkennen.

13. System nach Anspruch 12, wobei das Analysetool ferner so konfiguriert ist, dass es die für den Prüfbereich (121) der Struktur (101) generierten Sensordaten (106) unter Verwendung der Abstandsdaten (110) analysiert, um das Vorhandensein einer Inkonsistenz in der Struktur (101) zu erkennen, oder wobei optional das Analysetool (104) ferner zum Generieren einer Visualisierungsausgabe der Abstandsdaten (110) konfiguriert ist.

14. System nach Anspruch 13, ferner umfassend eine Anzeigevorrichtung, wobei das Analysetool (104) ferner so konfiguriert ist, dass es die Visualisierungsausgabe auf einer Anzeigevorrichtung anzeigt, wobei die Visualisierungsausgabe eine Dickenkarte umfasst.

15. System nach einem der Ansprüche 12 bis 14, wobei das Analysetool (104) ferner so konfiguriert ist, dass es unter Verwendung der Abstandsdaten (110) eine Funktion (126) generiert, die es ermöglicht, an jedem ausgewählten Punkt entlang der Außenfläche (114) einen Abstand zwischen der Außenfläche (114) und der Innenfläche (118) durch die Funktion zu berechnen.

## Revendications

1. Procédé mis en oeuvre par ordinateur pour inspecter une structure (101), le procédé comprenant :
l'identification (702) d'une surface de balayage (120) qui représente une zone d'inspection (121) de la structure (101) ;
la génération (704) d'une pluralité de points échantillons (122) sur une surface externe (114) identifiée à partir d'un modèle (112) de la structure (101) et d'une pluralité correspondante de points projetés (123) sur une surface interne (118) identifiée à partir du modèle (112) de la structure (101) au moyen de la surface de balayage (120), d'une première représentation géométrique (400) de la surface externe (114), et d'une deuxième représentation géométrique de la surface interne (118) ;
le calcul (706) de données de distance (110) au moyen de la pluralité de points échantillons (122) et de la pluralité correspondante de points projetés (123), les données de distance (110) incluant une distance entre les points de chaque paire de points correspondants (paire point échantillon-point projeté) issue des points échantillons (122) et des points projetés (123) ; et
l'analyse (710) de données de capteurs (106) générées pour la zone d'inspection (121) de la structure (101) au moyen des données de distance (110) pour détecter la présence d'une incohérence dans la structure (101).

2. Procédé selon la revendication 1, comprenant en outre :
la génération (708) d'un résultat de visualisation (128) des données de distance (110) (702), ou éventuellement la génération (1224) d'une fonction (126) au moyen des données de distance (110), ce qui permet de calculer une distance entre la surface externe (114) et la surface interne (118) par le biais de la fonction (126) à n'importe quel point sélectionné le long de la surface externe (114).

3. Procédé selon l'une quelconque des revendications 1 et 2, dans lequel l'identification (702) de la surface de balayage (120) comprend :
l'identification (802) de coordonnées (200) pour la zone d'inspection (121) de la structure (101) ;
la création (804) d'une surface initiale (202) au moyen des coordonnées (200) ;
la génération (810) d'une forme convexe (204) pour la surface initiale (202) ; et
la formation (812) de la surface de balayage (120) au moyen de la forme convexe (204) de telle sorte que la surface de balayage (120) ait une forme sensiblement convexe.

4. Procédé selon la revendication 3, dans lequel la génération (704) de la pluralité de points échantillons (122) sur la surface externe (114) comprend en outre :
l'identification (904) d'une pluralité de points de balayage (304) sur la surface de balayage ;
le traitement (908), pour chaque point de balayage sélectionné de la pluralité de points de balayage (304), de la zone de surface concernée pour identifier un morceau de la zone de surface concernée qui est le plus proche du point de balayage sélectionné ; et
la formation (910), pour chaque point de balayage sélectionné de la pluralité de points de balayage (304), d'un point échantillon de la pluralité de points échantillons (122) au moyen d'un point sur le morceau par lequel passe un vecteur qui est sensiblement normal à la surface de balayage (120) à un emplacement du point de balayage sélectionné.

5. Procédé selon la revendication 4, dans lequel l'identification (904) de la pluralité de points de balayage (304) comprend :
l'identification (1302) d'une pluralité de courbes de référence pour la surface de balayage (120) correspondant à une pluralité de chemins empruntés par un système de capteurs (102) pour balayer la zone d'inspection (121) de la structure (101) ; et
la formation (1304) de la pluralité de points de balayage (304) au moyen de la pluralité de courbes de référence et d'une distance d'espacement utilisée par le système de capteurs (102).

6. Procédé selon la revendication 5, dans lequel la formation (1304) de la pluralité de points de balayage (304) comprend :
l'identification de points le long de chaque courbe de référence de la pluralité de courbes de référence sur la base de la distance d'espacement pour former une collection de points ; et
la sélection d'une partie de la collection de points qui se situe à l'intérieur d'une limite correspondant à la zone d'inspection (121) pour former la pluralité de points de balayage (304).

7. Procédé selon la revendication 3, dans lequel l'identification (902) de la zone de surface concernée comprend :
la génération (1102) de la première représentation géométrique de la surface externe (114), la première représentation géométrique comprenant une pluralité de morceaux ;
l'échantillonnage (1104) de la première représentation géométrique pour générer des points d'échantillonnage ;
la réduction (1108) des points d'échantillonnage à une collection ciblée de points d'échantillonnage au moyen d'un algorithme d'indexation spatiale (124) ; et
la formation (1110) de la zone de surface concernée sur la base de la collection ciblée de points d'échantillonnage, la zone de surface concernée comprenant une partie sélectionnée de la pluralité de morceaux.

8. Procédé selon l'une quelconque des revendications 1 à 7, dans lequel la génération (704) de la pluralité correspondante de points projetés (123) sur la surface interne (118) comprend :
l'identification (1002) d'une zone de surface concernée qui représente une partie de la surface interne (118) correspondant à la surface de balayage (120).

9. Procédé selon la revendication 8, dans lequel la génération (704) de la pluralité correspondante de points projetés (123) sur la surface externe (118) comprend en outre :
le traitement (1004), pour chaque point échantillon sélectionné de la pluralité de points échantillons (122),
de la zone de surface concernée pour identifier un morceau de la zone de surface concernée qui est le plus proche du point échantillon sélectionné ; et
la formation (1104), pour chaque point échantillon sélectionné de la pluralité de points échantillons (122),
d'un point projeté au moyen d'un point sur le morceau par lequel passe un vecteur qui est sensiblement normal à la surface externe (114) à un emplacement du point échantillon sélectionné.

10. Procédé selon la revendication 8, dans lequel l'identification (1002) de la zone de surface concernée comprend :
la génération (1102) de la deuxième représentation géométrique de la surface interne (118), la deuxième représentation géométrique comprenant une pluralité de morceaux ;
l'échantillonnage (1104) de la deuxième représentation géométrique pour générer des points d'échantillonnage ;
la réduction (1108) des points d'échantillonnage à une collection ciblée de points d'échantillonnage au moyen d'un algorithme d'indexation spatiale (124) ; et
la formation (1110) de la zone de surface concernée sur la base de la collection ciblée de points d'échantillonnage, la zone de surface concernée comprenant une partie sélectionnée de la pluralité de morceaux.

11. Procédé selon l'une quelconque des revendications 1 à 10, dans lequel la pluralité de points d'échantillonnage et la pluralité correspondante de points projetés (123) forment une pluralité de paires de points et dans lequel le calcul (706) des données de distance (110) comprend :
le calcul d'une distance entre les points de chaque paire de points de la pluralité de paires de points.

12. Système comprenant :
une mémoire (1514) destinée à stocker un support lisible par machine comprenant un code exécutable par machine ; et
un processeur (1504) couplé à la mémoire (1514) et configuré pour exécuter le code exécutable par machine pour conduire le processeur (1504) à mettre en oeuvre un outil d'analyse (104) configuré pour :
identifier une surface de balayage (120) qui représente une zone d'inspection (121) d'une structure (101) ;
générer une pluralité de points échantillons (122) sur une surface externe (114) identifiée à partir d'un modèle (112) de la structure (101) et une pluralité correspondante de points projetés (123) sur une surface interne (118) identifiée à partir du modèle (112) de la structure (101) en utilisant la surface de balayage, une première représentation géométrique de la surface externe (114), et une deuxième représentation géométrique de la surface interne (118) ; et
calculer des données de distance (110) en utilisant la pluralité de points échantillons (122) et la pluralité correspondante de points projetés (123), les données de distance (110) identifiant une distance entre les points d'une paire de points formée par un point échantillon de la pluralité de points échantillons (122) et un point projeté de la pluralité correspondante de points projetés (123) ; le système comprenant en outre
un système de capteurs destiné à générer des données de capteurs ; l'outil d'analyse étant en outre configuré pour analyser les données de capteurs générées pour la zone d'inspection de la structure en utilisant les données de distance pour détecter la présence d'une incohérence dans la structure.

13. Système selon la revendication 12, dans lequel l'outil d'analyse est en outre configuré pour analyser les données de capteurs (106) générées pour la zone d'inspection (121) de la structure (101) en utilisant les données de distance (110) pour détecter la présence d'une incohérence dans la structure (101), ou éventuellement dans lequel l'outil d'analyse (104) est en outre configuré pour générer un résultat de visualisation des données de distance (110).

14. Système selon la revendication 13, comprenant en outre un dispositif d'affichage, dans lequel l'outil d'analyse (104) est en outre configuré pour afficher le résultat de visualisation sur le dispositif d'affichage, le résultat de visualisation comprenant une carte d'épaisseurs.

15. Système selon l'une quelconque des revendications 12 à 14, dans lequel l'outil d'analyse (104) est en outre configuré pour générer une fonction en utilisant les données de distance (110), ce qui permet de calculer une distance entre la surface externe (114) et la surface interne (118) par le biais de la fonction à n'importe quel point sélectionné le long de la surface externe (114) .
